# EUROPEAN PATENT APPLICATION

(11) **EP 2 450 960 A1**
(43) Date of publication of application: **09.05.2012**
(21) Application number: 10794131.2
(22) Date of filing: 29.06.2010
(51) Int. Cl.: H01L 31/04

(54) **METHOD FOR MANUFACTURING PHOTOELECTRIC CONVERSION ELEMENTS, DEVICE FOR MANUFACTURING PHOTOELECTRIC CONVERSION ELEMENTS, AND PHOTOELECTRIC CONVERSION ELEMENT**

(30) Priority: 29.06.2009 JP 2009154340
(71) Applicant: Kyocera Corporation, Kyoto-shi, Kyoto 612-8501 (JP)
(72) Inventor: MATSUSHIMA, Norihiko, Higashiomi-shi Shiga 527-8555 (JP); NISHIMURA, Daisuke, Higashiomi-shi Shiga 527-8555 (JP); HATATE, Atsuo, Higashiomi-shi Shiga 527-8555 (JP); OHKUMA, Takeshi, Higashiomi-shi Shiga 527-8555 (JP); ARIMUNE, Hisao, Higashiomi-shi Shiga 527-8555 (JP); HASHIMOTO, Yukari, Higashiomi-shi Shiga 527-8555 (JP)
(74) Representative: Witte, Weller & Partner
(86) International application number: PCT/JP2010/061030
(87) International publication number: WO 2011/001962

(57) **Abstract**

An embodiment of a method of manufacturing a photoelectric conversion device according to the present invention includes specifying a spot having an abnormal physical property in a structure comprising a photoelectric conversion member, including a semiconductor layer, between a pair of first and second electrodes, and isolating the spot having an abnormal physical property through machining.

## Description

### TECHNICAL FIELD

The present invention relates to a photoelectric conversion device and a method of manufacturing the same, and an apparatus for manufacturing the photoelectric conversion device.

### BACKGROUND ART

Various types of photoelectric conversion devices are used for photovoltaic power generation and the like. With respect to a photoelectric conversion device constituted by a chalcopyrite type semiconductor layer, which is represented by a CIS type (copper indium selenide type) semiconductor layer, or an amorphous silicon type semiconductor layer, since an area of a photoelectric conversion module can be easily increased at a comparatively low cost, a research and development has been progressed.

The chalcopyrite type photoelectric conversion device includes semiconductor layers such as a light absorbing layer and a buffer layer. Since the light absorbing layer and the buffer layer have thicknesses of several µm, a spot having an abnormal film property partially occurs in some cases. When there is such an abnormal spot, a photocurrent is locally reduced or a leakage current is increased. Therefore, photoelectric conversion efficiency of the photoelectric conversion device is remarkably reduced or reliability thereof is deteriorated in some cases.

Reliability of an amorphous silicon type photoelectric conversion device may be similarly deteriorated depending on the film property as described above. On the other hand, there is known a repair method of applying a backward bias voltage to the amorphous silicon type photoelectric conversion device and observing a heat generation spot at that time by means of an infrared camera to specify a spot in which a leakage current is generated, and then irradiating the spot in which the leakage current is generated with a laser beam to remove an electrode or the like in that part (see Patent Document 1).

### PRIOR ART DOCUMENT

### PATENT DOCUMENT

Patent Document 1: Japanese Patent Application Laid-Open No. 9-266322 (1997)

### SUMMARY OF THE INVENTION

### PROBLEMS TO BE SOLVED BY THE INVENTION

however, referring to amorphous silicon type and chalcopyrite type semiconductor layers, in cases where a spot having an abnormal physical property is irradiated with a laser beam in order to remove a part thereof, the semiconductor layers are molten and a temperature in the vicinity of the portion irradiated with the laser beam is raised so that quality of a film is deteriorated, resulting in a reduction in photoelectric conversion efficiency. In particular, in a chalcopyrite type compound semiconductor layer, a copper based compound contained therein short-circuits upper and lower electrodes in some cases.

An object of the present invention is to provide a photoelectric conversion device having high efficiency by satisfactorily isolating a partial spot having an abnormal physical property which is generated in the photoelectric conversion device.

### MEANS FOR SOLVING THE PROBLEMS

An embodiment of a method of manufacturing a photoelectric conversion device according to the present invention includes specifying a spot having an abnormal physical property in a structure comprising a photoelectric conversion member, including a semiconductor layer, between a pair of first and second electrodes; and isolating the spot having an abnormal physical property through machining.

An embodiment of an apparatus for manufacturing a photoelectric conversion device according to the present invention provides an apparatus for manufacturing a photoelectric conversion device including a mechanism for isolating a spot having an abnormal physical property in a structure comprising a photoelectric conversion member, including a semiconductor layer, between a pair of first and second electrodes, and the apparatus comprises a voltage applying unit for applying a bias voltage to the structure and a detecting unit for detecting an intensity of an electromagnetic wave emitted from the structure. Furthermore, the embodiment of the apparatus for manufacturing a photoelectric conversion device according to the present invention includes a specifying unit for specifying the spot having an abnormal physical property based on the intensity of the electromagnetic wave, and a machining unit for carrying out machining over the structure to isolate the spot having an abnormal physical property.

An embodiment of a photoelectric conversion device according to the present invention includes a structure comprising a photoelectric conversion member, including a semiconductor layer, between a pair of first and second electrodes, wherein, the structure was formed with the separation of a spot having an abnormal physical property by the machining.

### EFFECTS OF THE INVENTION

In accordance with the embodiment of the method of manufacturing a photoelectric conversion device and the apparatus for manufacturing a photoelectric conversion device according to the present invention, by isolating the spot having an abnormal physical property of the structure included in the photoelectric conversion device through machining, it is possible to suppress a rise in temperature in the spot having an abnormal physical property and a peripheral portion thereof. In the present embodiment, since the spot having an abnormal physical property is isolated through the machining, it is possible to reduce degeneration in the semiconductor layer due to heat generated by laser irradiation or the like. As a result, in the present embodiment, it is possible to provide a photoelectric conversion device having high efficiency.

### BRIEF DESCRIPTION OF THE DRAWINGS

Fig. 1 is a sectional view showing an example of a structure of a photoelectric conversion device according to the present invention.
Fig. 2 is a block diagram for describing an example of a method of manufacturing a photoelectric conversion device according to the present invention.
Fig. 3 is a view showing an example of an apparatus for manufacturing a photoelectric conversion device according to the present invention.
Fig. 4 is a perspective view showing a state of execution of machining according to the present invention.
Figs. 5(a) to 5(c) are perspective views showing an example of the photoelectric conversion device that has been subjected to the machining in an isolating step.
Figs. 6(a) to 6(c) are plan views showing various embodiments of a tip portion of a scriber.
Fig. 7 shows an example of the photoelectric conversion device that has been subjected to the machining in the isolating step, where (a) is a plan view seen from a window layer side, and (b) to (d) are sectional views.
Figs. 8(a) and 8(b) are perspective views showing various embodiments of the tip portion of the scriber.

### EMBODIMENT FOR CARRYING OUT THE INVENTION

An embodiment of a photoelectric conversion device according to the present invention will be described. In the following embodiment, description will be given by using a mode of a photoelectric conversion device comprising a chalcopyrite type semiconductor layer.

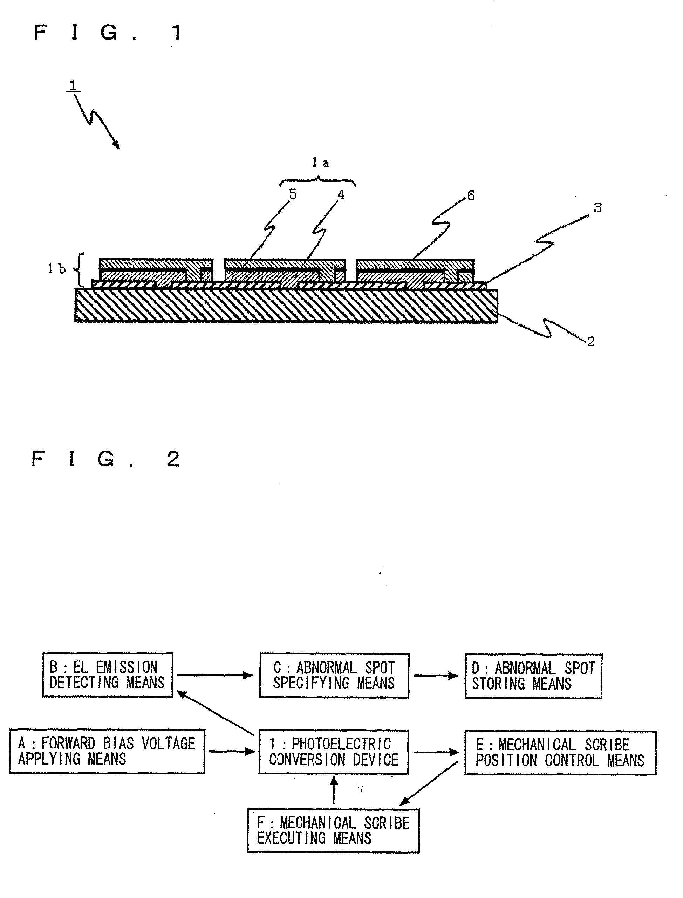

A chalcopyrite type photoelectric conversion device comprises a structure comprising a photoelectric conversion member including a chalcopyrite type compound semiconductor layer and a pair of electrodes (first and second electrodes). The photoelectric conversion member may include a buffer layer subjected to heterojunction to the chalcopyrite type compound semiconductor layer. Moreover, the electrodes include an electrode formed of a semiconductor layer and an electrode referred to as a so-called window layer. A photoelectric conversion device 1 shown in Fig. 1 comprises a substrate 2, a back electrode 3 as the first electrode, a chalcopyrite type compound semiconductor layer 4, a buffer layer 5, and a window layer 6 as the second electrode. In the present embodiment, a photoelectric conversion member 1a is constituted by the semiconductor 4 and the buffer layer 5. In the present embodiment, furthermore, a structure 1b is constituted by the back electrode 3, the photoelectric conversion member 1a, and the second electrode.

The substrate 2 is formed of a blue plate glass (a soda lime glass) having a thickness of approximately 1 to 3 mm, for example. Moreover, the back electrode 3 is constituted by a metal such as molybdenum, titanium or tantalum having a thickness of approximately 0.2 to 1 µm or their metal layered product having a thickness of approximately 0.2 to 1 µm, for example.

The chalcopyrite type compound semiconductor layer 4 functions as a light absorbing layer. The semiconductor layer 4 is a thin semiconductor film comprising a chalcopyrite structure in a thickness of approximately 1 to 3 µm having a p-type conductivity and is a thin semiconductor film of copper indium diselenide, copper indium gallium diselenide, copper indium gallium diselenide sulfide or copper indium gallium disulfide, or a multi-component compound thin semiconductor film such as copper indium gallium diselenide including a thin copper indium gallium diselenide sulfide layer as a surface layer.

The buffer layer 5 is a mixed crystal compound semiconductor such as cadmium sulfide (CdS), indium sulfide (In₂S₃) or zinc sulfide (ZnS).

The window layer 6 is a transparent thin semiconductor film having a great band gap, a low resistance and a thickness of approximately 1 to 2 µm with an n-type conductivity, and formed of metal oxide constituted by zinc oxide (ZnO), a compound with zinc oxide containing aluminum, boron, gallium, indium, fluorine, or the like, indium tin oxide (ITO) or tin oxide (SnO₂) containing tin, or the like. The window layer 6 can be regarded as one of the electrodes (the second electrode) constituting the photoelectric conversion device 1. A transparent conductive film may further be formed in addition to the window layer 6, and the window layer 6 together with the transparent conductive film may be regarded as the second electrode.

Description will be given to an example of steps of fabricating the photoelectric conversion device 1 according to the present embodiment. First of all, the back electrode 3 is formed, by using a sputtering process or the like, over almost a whole surface of the substrate 2 which is cleaned. Next, a dividing groove is formed, by using a YAG laser or the like, on the back electrode 3 thus formed so that the back electrode 3 is subjected to patterning. Thereafter, the chalcopyrite type compound semiconductor layer 4 is provided on the back electrode 3 having the pattern formed thereon by using the sputtering process, a vapor deposition process, a printing process, or the like. Subsequently, the buffer layer 5 is formed by using a solution growth process (a CBD process) or the like. A dividing groove is formed on the chalcopyrite type compound semiconductor layer 4 and the buffer layer 5 which are formed over almost a whole surface of the back electrode 3 through mechanical scribing so that the chalcopyrite type compound semiconductor layer 4 and the buffer layer 5 are subjected to patterning. Then, the window layer 6 is provided on almost a whole surface of the buffer layer 5 by using the sputtering process, an organic metal chemical vapor deposition process (an MOCVD process), or the like, and a dividing groove is formed through the mechanical scribing so that the window layer 6 is subjected to patterning. By printing a silver paste or the like on the window layer 6 in order to reduce a resistance, it is also possible to form a grid electrode.

Thus, the photoelectric conversion device 1 comprises a structure in which the substrate 2, the back electrode 3, the chalcopyrite type compound semiconductor layer 4, the buffer layer 5, and the window layer 6 are provided from a back side in this order, and comprises an integrated structure in which the respective layers are subjected to patterning so that a plurality of unit cells are electrically connected as shown in Fig. 1.

Next, a method of manufacturing a photoelectric conversion device according to the present invention will be described with reference to Fig. 2. First of all, as shown in Fig. 2, a forward bias voltage is applied between the electrodes of the photoelectric conversion device 1 by forward bias voltage applying means A (a voltage applying unit). Consequently, an electroluminescence (which will be hereinafter referred to as EL) emitted from the photoelectric conversion device 1 is detected by EL emission detecting means B (a detecting unit).

By observing the EL from the photoelectric conversion device 1, it is possible to obtain a current density distribution in the photoelectric conversion device in the application of the forward bias voltage, thereby knowing a spot having an abnormal physical property in the photoelectric conversion device 1 based on nonuniformity of the current density distribution. In other words, it is apparent that there is a defective event such as a pn junction failure, a presence of a microcrack, a composition shift, a portion having a high defect density at which a recombination tends to be caused, an abnormality of a contact resistance between the respective layers or between the electrode and the semiconductor layer, or the like in a portion having no EL emission or a portion having a lower emission intensity than in the other portions. Then, a state of the EL emission over an observing surface of the photoelectric conversion device 1 is observed to specify a spot having an abnormal physical property (hereinafter simply referred to as an abnormal spot in some cases) by abnormal spot specifying means C (a specifying unit) and coordinates of the abnormal spot are stored in abnormal spot storing means D. Based on information about the abnormal spot which is stored, mutual positions of the photoelectric conversion device 1 and mechanical scribe executing means F (a machining unit) controlled by mechanical scribe position control means E are regulated to electrically isolate the abnormal spot from a periphery or to remove a film in that portion. In other words, the method of manufacturing a photoelectric conversion device according to the present invention includes an isolating step of isolating the spot having an abnormal physical property of the photoelectric conversion device 1 through machining.

As described above, at the step of specifying the spot having an abnormal physical property in the photoelectric conversion device 1, it is possible to specify, by using an EL emission detector B, a spot having an abnormal physical property within a wider range such as a pn junction failure, a presence of a microcrack, a composition shift, a portion having a high defect density in which a recombination tends to be caused, an abnormality of a contact resistance between the respective layers or between the electrode and the semiconductor layer, or the like, in addition to a spot in which a leakage current is generated due to an abnormality of a film property. Therefore, a repair effect for isolating a spot having an abnormal physical property from a normal portion can be more excellent through the specifying step.

The means for specifying the spot having an abnormal physical property is not limited to the EL emission detection but may detect an infrared ray which is generated when a forward bias voltage or a backward bias voltage is applied to the photoelectric conversion device 1. By thus detecting an intensity distribution of an electromagnetic wave of the EL, the infrared ray, or the like, it is possible to specify the spot having an abnormal physical property in the photoelectric conversion device 1.

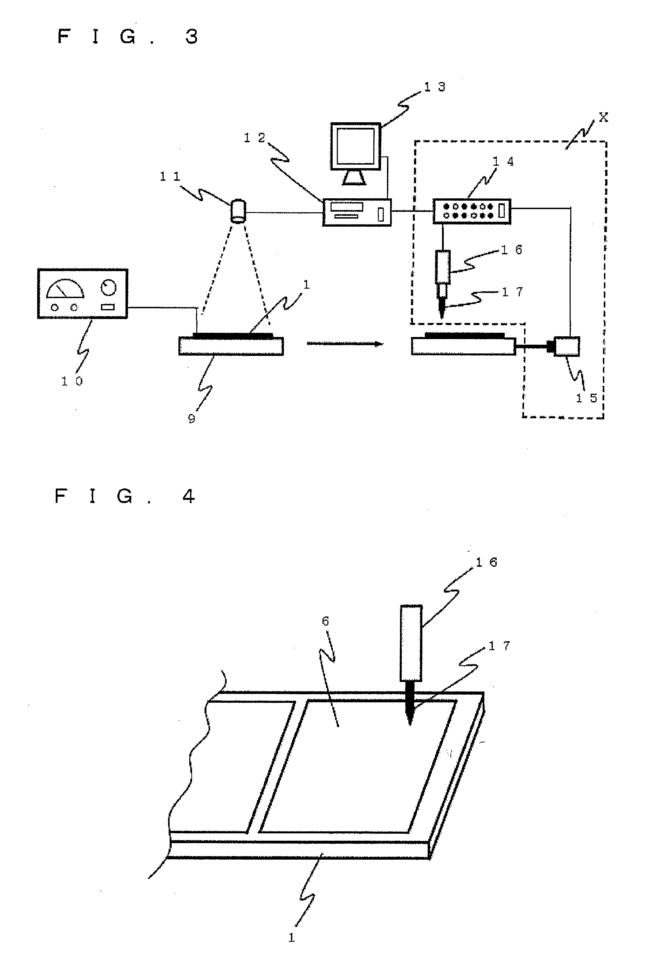

Next, an example of an apparatus (a repairing apparatus) for manufacturing a photoelectric conversion device according to the present invention will be described with reference to Fig. 3. The apparatus for manufacturing a photoelectric conversion device according to the present embodiment includes a mounting table 9, a voltage applying unit 10, an observing camera 11 forming a part of the detecting unit, a computer 12 serving as a specifying unit, and a display 13. Furthermore, the apparatus for manufacturing a photoelectric conversion device according to the present embodiment includes a machining unit X comprising a sequencer 14, a servomotor 15, scriber up-down means 16, and a scriber 17.

The mounting table 9 is fabricated by a flat plate made of stainless having a thickness of approximately 10 mm, for example, and a plurality of through holes (not shown) is provided in an almost central part thereof. By using decompressing means such as a vacuum pump disposed in the vicinity of the mounting table 9, the photoelectric conversion device 1 mounted on the mounting table 9 can be fixed by decompression into a predetermined position via the through holes. In addition, the mounting table 9 is driven by two servomotors 15 controlled through the sequencer 14 and can be thus moved freely in an X - Y direction.

The scriber 17 is moved in a vertical direction by the scriber up-down means 16 controlled through the sequencer 14 such as an air cylinder.

Next, description will be given to an operation of the apparatus (the repairing apparatus) for manufacturing a photoelectric conversion device according to the present invention.

In the photoelectric conversion device 1 mounted and fixed to a predetermined position of the mounting table 9, a forward bias voltage is applied between the electrodes (the back electrode 3 and the window layer 6) by the voltage applying unit 10. In other words, the voltage applying unit serves to apply a bias voltage to the structure 1b constituted by the photoelectric conversion member 1a and a pair of electrodes. It is suitable that a bias voltage value to be applied in the photoelectric conversion device 1 is approximately 0.2 to 1 V per unit cell connected in series in the photoelectric conversion device 1. A voltage value to be actually applied is obtained through a multiplication by a series number in the photoelectric conversion device 1.

Since a spot having an abnormal physical property carries out an EL emission by the application of the bias voltage in the photoelectric conversion device 1, an image of the EL emission state is picked up by means of the observing camera 11 and an image signal is transmitted to the computer 12. In other words, a detecting unit formed by the observing camera 11 serves to detect an intensity of an electromagnetic wave of the EL emission or the like from the structure 1b forming a part of the photoelectric conversion device 1. The transmitted image signal is displayed on the display 13, and furthermore, the EL emission state of the photoelectric conversion device 1 is A/D converted in the computer 12 and a gray multilevel image thus obtained is made binary based on a threshold having a predetermined gray level to specify a dark portion, and the dark portion is decided to be a spot having an abnormal physical property and two-dimensional coordinates thereof are stored.

Since such an EL emission of the photoelectric conversion device 1 is feeble, it is preferable that the image of the EL emission state be picked up by means of the observing camera 11 in a dark room or a black box in order to avoid an influence of stray light or the like.

Then, the servomotor 15 is controlled by the sequencer 14 and the mounting table 9 having the photoelectric conversion device 1 mounted thereon is moved to a scribe executing position in which the spot having an abnormal physical property is to be isolated by machining, and furthermore, the abnormal spot of the photoelectric conversion device 1 is brought to a position placed under the scriber 17 as shown in Fig. 4. Thereafter, an up-down movement of the scriber 17 through the scriber up-down means 16 and the movement of the mounting table 9 (the photoelectric conversion device 1) are combined to carry out mechanical scribing over a peripheral film of the abnormal spot of the photoelectric conversion device 1, thereby electrically cutting or removing the film in the abnormal spot from a periphery. Thus, the spot having an abnormal physical property is isolated from a normal portion.

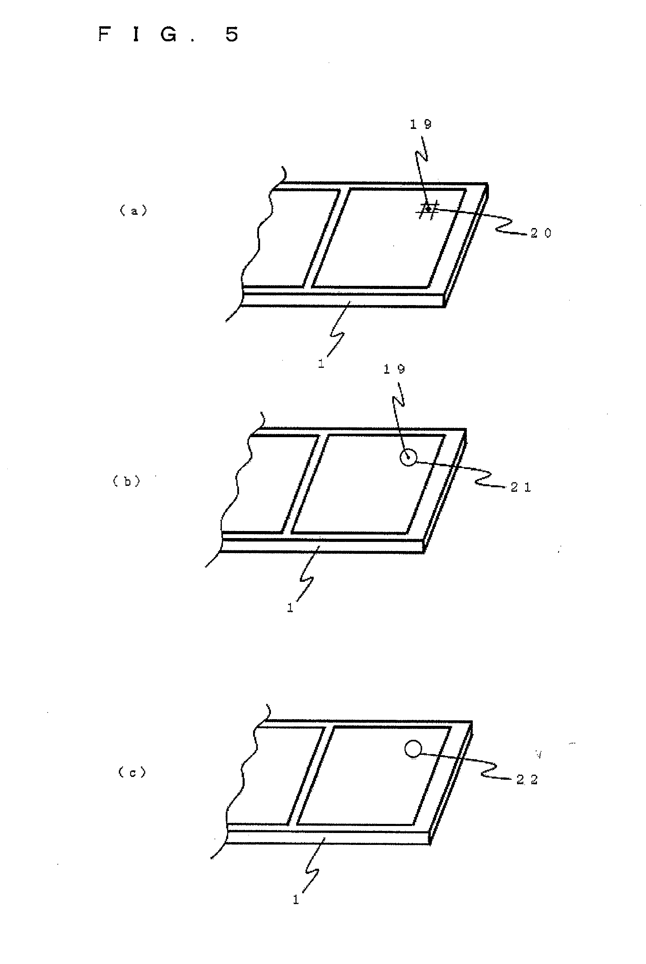

In the photoelectric conversion device 1 that has been subjected to the mechanical scribe, an abnormal spot 19 is isolated from the other normal portions through a groove 20 or a groove 21 formed by the mechanical scribing as shown in Figs. 5(a) and 5(b). Moreover, Fig. 5(c) shows an example in which a groove 22 is formed to remove the abnormal spot from the structure 1b of the photoelectric conversion device 1. In the following description, as shown in Fig. 5(c), a portion in which the abnormal spot 19 is removed from the structure 1b is referred to as a first portion 22. Furthermore, as shown in Figs. 5(a) and 5(b), a portion in which a part of the structure 1b is removed linearly to surround the abnormal spot so that the abnormal spot is electrically divided from a peripheral part is referred to as a second portion. In other words, in the present embodiment, the groove 20 or the groove 21 corresponds to the second portion.

For a machining unit to be used for the isolating step of isolating such an abnormal spot through machining, for example, a diamond scriber comprising a sharp diamond piece fixed to a tip of the scriber 17, a hard blade made of tungsten carbide, or the like is used. The groove 20 is formed through the mechanical scribe to surround the abnormal spot 19 as shown in Fig. 5(a), and the back electrode 3, the chalcopyrite type compound semiconductor layer 4, the buffer layer 5, the window layer 6, a grid electrode (not shown), and the like in this portion are electrically isolated from a peripheral portion.

By thus electrically isolating the abnormal spot 19 through the groove 20, heat generation over each layer in the photoelectric conversion device 1 which is observed in irradiation of a laser beam rarely occurs. Therefore, it is possible to prevent the chalcopyrite type compound semiconductor layer 4 from being molten to cause a leakage or quality of a film in a peripheral part from being deteriorated. Furthermore, the isolation (repair) is carried out through the very small groove 20, and consequently, it is possible to suppress deterioration in an appearance seen from a light receiving surface side of the photoelectric conversion device 1.

Moreover, it is also possible to remove the peripheral portion 21 of the abnormal spot 19 circularly as shown in Fig. 5(b) by using a tool obtained by attaching a planar diamond file or sand paper, a metallic brush, or the like to a tip of the scriber 17. Consequently, it is possible to efficiently isolate (repair) the abnormal spot 19 in a comparatively large spot in addition to the specific advantage of the above-described mechanical scribe.

In the isolating step described above, although all of the back electrode 3, the chalcopyrite type compound semiconductor layer 4, the buffer layer 5, the window layer 6, and the grid electrode (not shown) which constitute the photoelectric conversion device 1 are removed, it is also possible to employ a configuration in which only the window layer 6 is removed or the window layer 6 and the grid electrode are removed since it is sufficient if a contact between the back electrode 3 and the window layer 6 is suppressed in the isolating step. In this case, if the back electrode 3 provided on a main surface of the substrate 2 made of glass is formed of molybdenum, it is preferable that the isolating step is performed in a state in which the back electrode 3 is left on the main surface of the substrate 2. In this case, a scratch caused by the contact of the tip of the scriber 17 is formed over the back electrode 3 having a relatively higher elastic modulus than the glass substrate 2. Therefore, it is possible to prevent a crack from growing from this scratch as a starting point.

Referring to the configuration in which there is formed the groove-shaped first portion 22 for removing the abnormal spot from the structure 1b of the photoelectric conversion device 1 as shown in Fig. 5(c), moreover, it is possible to suppress an occurrence of such a defect that an abnormal spot and a normal portion come in contact with each other through a conductive substance or the like which is mixed into the photoelectric conversion device 1. Therefore, it is possible to enhance the reliability of the photoelectric conversion device 1 more greatly.

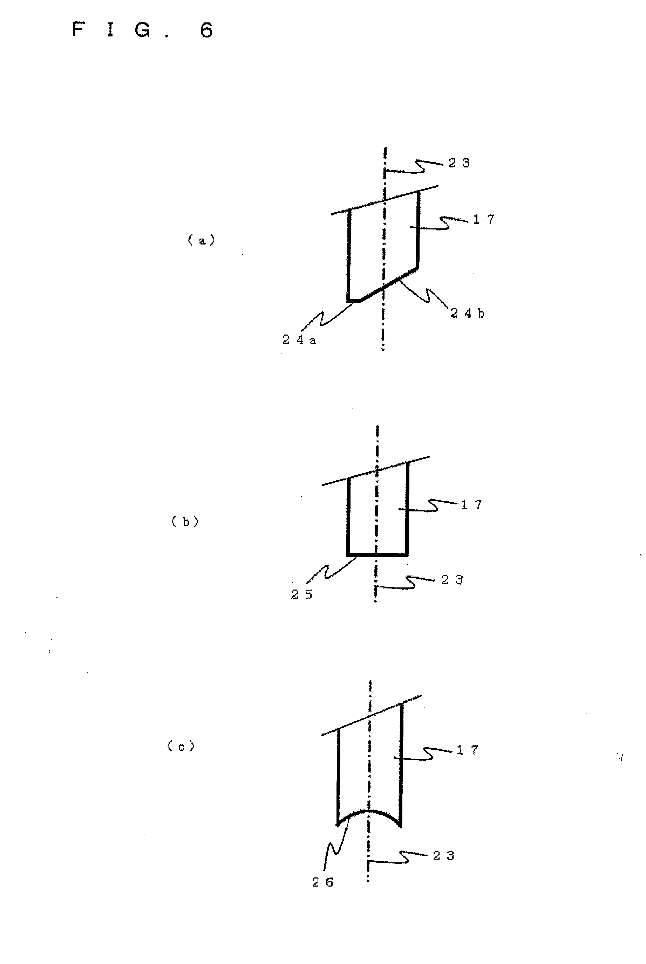

Next, a shape of the scriber 17 will be described with reference to Fig. 6. The scriber 17 has a flat plate shape with a thickness of approximately 0.1 to 0.5 mm, for example. Moreover, the scriber 17 has a width of approximately 0.2 to 3.0 mm, for example. The scriber 17 is provided to be rotated around a rotating axis 23 as shown in Fig. 6.

The tip portion of the scriber 17 shown in Fig. 6(a) has such a shape as to include a horizontal portion 24a and an inclined portion 24b, and is wholly formed in a flat plate. The horizontal portion 24a has a size of approximately 1/10 to 1/5 of a width of the tip portion of the scriber 17, for example. Furthermore, the other end of the scriber 17 is coupled to a motor or the like. In the isolating step using the scriber 17, the rotating axis 23 of the scriber 17 is adjusted to an almost central part of the abnormal spot 19 and the scriber 17 is pushed down with a rotation at a speed of approximately 10 to 100 rotations per second until the horizontal portion 24a abuts on the back electrode 3 of the photoelectric conversion device 1. In the scriber 17, the semiconductor layer 4, the buffer layer 5, and the window layer 6 which correspond to the abnormal spot 19 can be isolated from a normal portion through the rotation of the horizontal portion 24a. In the case where the scriber 17 has a flat plate shape, the tip portion may have a rectangular shape 25 with a constant thickness and width as shown in Fig. 6(b), for example. In this case, the tip portion of the scriber 17 may have such a shape that a thickness is gradually reduced toward the tip. On the other hand, the scriber 17 may have such a shape that a surface of the tip portion is dented like a circular arc 26 as shown in Fig. 6(c).

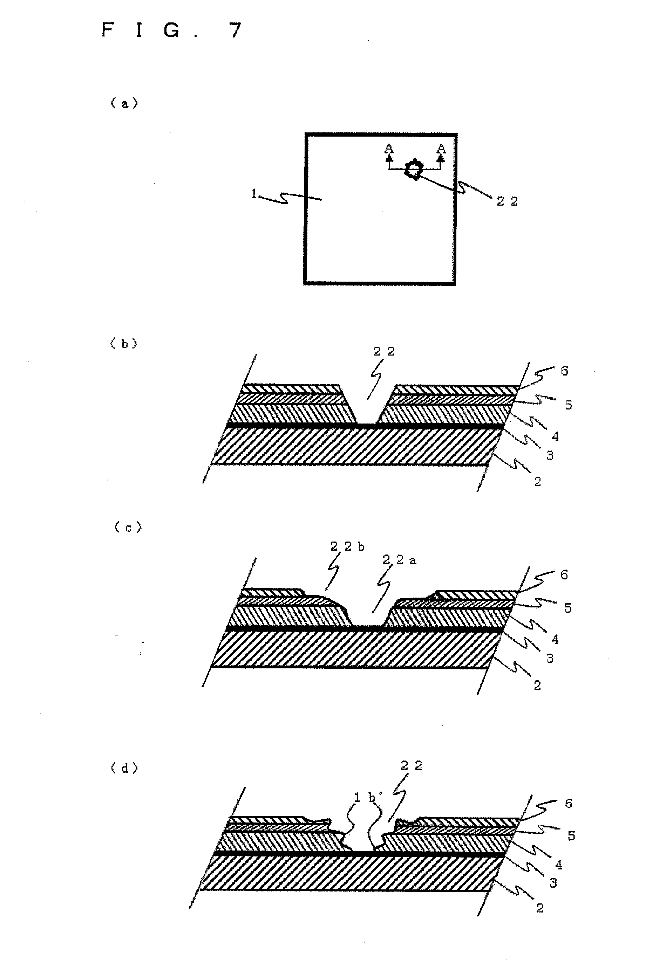

Moreover, in the step of isolating the abnormal spot 19, as shown in Fig. 7(b), it is preferable that a hole portion provided as the first portion 22 in a laminating direction of the back electrode 3, the photoelectric conversion member 1a, and the window layer 6 is formed so as to gradually reduce a sectional area from the window layer 6 side toward the back electrode 3 side. With such a configuration, an inner peripheral surface of the structure 1b facing the first portion 22 (the hole portion) is inclined with respect to the laminating direction. Therefore, in the present embodiment, it is possible to increase a distance between the back electrode 3 and the window layer 6 which are exposed from the inner peripheral surface of the structure 1b. In the present embodiment, thus, it is possible to reduce generation of a short circuit of the back electrode 3 and the window layer 6 through a residue of the structure 1b which is caused in the isolation of the abnormal spot 19. It should be noted that the shape of the first portion 22 is not limited to a taper shape shown in Fig. 7(b) but may include such a configuration that a sectional area is gradually reduced.

Moreover, in the step of isolating the abnormal spot 19, as shown in Fig. 7(c), it is preferable that a hole portion provided as the first portion 22 in a laminating direction of the back electrode 3, the photoelectric conversion member 1a, and the window layer 6 is formed such that a first hole portion 22a is positioned on an inside of a second hole portion 22b in planar view from a surface side of the back electrode 3, with the first hole portion 22a penetrating through the back electrode 3 and the photoelectric conversion member 1a, and the second hole portion 22b penetrating through the window layer 6. With such a configuration, it is possible to more greatly increase the distance between the back electrode 3 and the window layer 6 which are exposed from the inner peripheral surface of the structure 1b, and the generation of the short circuit can be reduced more greatly.

Furthermore, it is preferable that the first portion 22 or the groove 20 or 21 (the second portion) which is formed in the structure 1b is covered with a resin. With such a step, moisture or oxygen enters the photoelectric conversion member 1a from the repaired first or second portion so that a deterioration in the photoelectric conversion member 1a can be suppressed, and a reduction in photoelectric conversion efficiency can be suppressed. The above resin may be colored such that it can be seen in the same manner as the other portions when the photoelectric conversion device 1 is seen from the light receiving surface side. For the above resin, a resin having high insulating and bonding properties and an excellent weathering resistance is suitable, and for example, an epoxy resin, a phenol resin, a polyurethane resin, a polyimide resin, a melamine resin, or the like can be used.

In the case where the resin as described above is used, if the isolating step is carried out to provide a convex portion on the surface of the structure 1b which is opposed to the first portion 22 as shown in Fig. 7(d), it is possible to reduce generation of coming off of the resin by an anchor effect of the convex portion. In the present embodiment, a convex portion 1b' may be provided on the surface of the structure 1b which is opposed to the second portion in addition to the first portion 22.

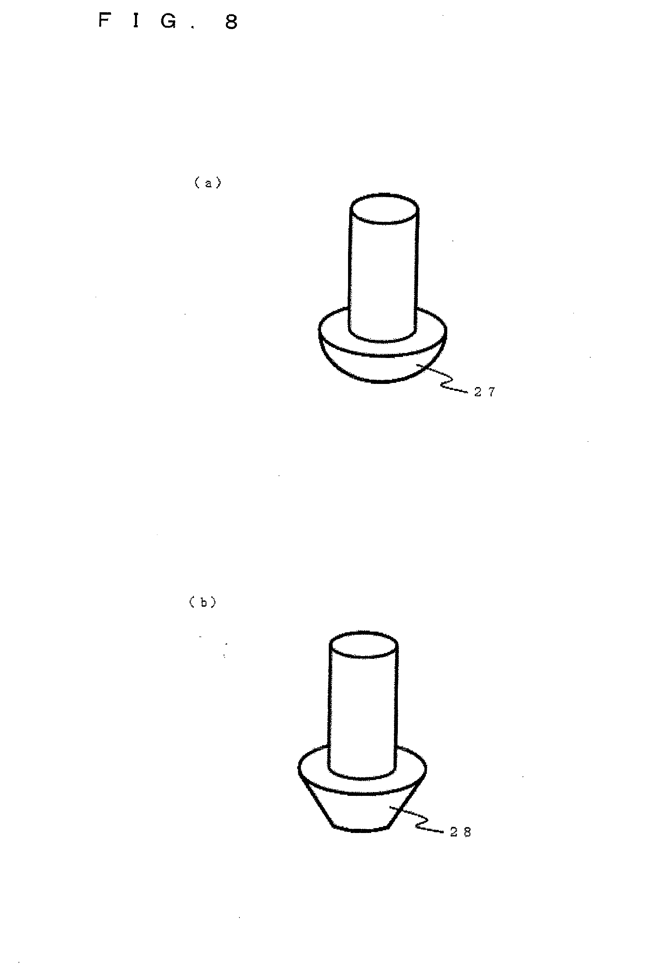

Furthermore, in order to form the first portion 22 or the second portion of which the sectional area is changed, it is preferable to properly select the shape of the tip portion of the scriber 17, for example, as a semicircular shape 27 shown in Fig. 8(a) or a circular truncated cone shape 28 shown in Fig. 8(b). Moreover, in order to form the convex portion 1b', it is sufficient to form a groove portion on the surface of the tip portion of the scriber 17.

The present invention is not limited to the above embodiment but many modifications and changes can be made without departing from the scope of the present invention. For example, at the step of specifying the abnormal spot 19, it is also possible to apply a backward bias voltage to the photoelectric conversion device 1, thereby causing a leakage spot to generate a heat, to observe an infrared ray emitted therefrom by means of an infrared camera and to specify the leakage spot, and to thereafter carry out the mechanical scribe over the leakage spot as described above. In this case, it is preferable to modulate a frequency, thereby applying the backward bias voltage. Consequently, it is possible to suppress a deterioration in the photoelectric conversion member 1a including the chalcopyrite type compound semiconductor layer around the leakage spot by the heat generation thereof. Thus, it is possible to increase photoelectric conversion efficiency.

Furthermore, in the step of specifying the abnormal spot 19 using the EL emission detecting means B, the EL emission detecting means B having a different resolution may be used for a plurality of times. Consequently, it is also possible to detect a defective spot on a several µm level from a substrate of a large-sized photoelectric conversion device including a side of 1m or more.

Moreover, although the photoelectric conversion device 1 includes the chalcopyrite type semiconductor layer 4 in the above embodiment, the invention can also be applied to a photoelectric conversion device including an amorphous silicon type semiconductor layer, for example. For example, in such a photoelectric conversion device, it is preferable that a first electrode is formed of aluminum or nickel, the photoelectric conversion member 1a is formed of an amorphous silicon semiconductor layer laminated in the order of an n-type, an i-type, and a p-type, and a second electrode is formed of indium tin oxide (ITO) containing tin, or the like. In this case, it is preferable that the first electrode is formed in a thickness of 200 to 500 nm by a vapor deposition process or a sputtering process. Moreover, in the photoelectric conversion member 1a, it is preferable that n-, i-, and p-type amorphous silicon are sequentially formed on the first electrode by a plasma CVD process or the like. Thereafter, ITO is formed in a thickness of 100 to 600 nm on the photoelectric conversion member by the sputtering process or the like, and the patterning shown in Fig. 1 is carried out by using a laser or the like, thereby fabricating the photoelectric conversion member 1a. In addition, the above-described amorphous silicon semiconductor layer may further contain microcrystalline silicon or polysilicon.

### DESCRIPTION OF REFERENCE SIGNS

1: photoelectric conversion device
1a: photoelectric conversion member
1b: structure
1b': convex portion 1b
2: substrate
3: back electrode
4: semiconductor layer
5: buffer layer
6: window layer
9: mounting table
10: voltage applying unit
11: observing camera (detecting unit)
12: computer (specifying unit)
13: display
14: sequencer
15: servomotor
16: scriber up-down means
17: scriber
19: spot having abnormal physical property (abnormal spot)
20, 21: groove (second portion)
22: first portion

## Claims

1. A method of manufacturing a photoelectric conversion device comprising:
specifying a spot having an abnormal physical property in a structure comprising a photoelectric conversion member, including a semiconductor layer, between a pair of first and second electrodes; and
isolating the spot having an abnormal physical property through machining.

2. The method of manufacturing a photoelectric conversion device according to claim 1, wherein the isolating serves to form, in the structure, a first portion as a portion from which the spot having an abnormal physical property is removed.

3. The method of manufacturing a photoelectric conversion device according to claim 1, wherein the isolating serves to remove a part of the structure linearly to surround the spot having an abnormal physical property; thereby forming a second portion as a portion in which the spot having an abnormal physical property is electrically divided from a peripheral portion.

4. The method of manufacturing a photoelectric conversion device according to claim 2, wherein a hole portion provided as the first portion in a laminating direction of the first electrode, the photoelectric conversion member, and the second electrode is formed such that a sectional area is reduced from the second electrode side toward the first electrode side.

5. The method of manufacturing a photoelectric conversion device according to claim 2, wherein a hole portion provided as the first portion in a laminating direction of the first electrode, the photoelectric conversion member, and the second electrode is formed such that a first hole portion is on an inside of a second hole portion in planar view from a surface side of the first electrode, with the first hole portion penetrating through the first electrode and the photoelectric conversion member, and the second hole portion penetrating through the second electrode.

6. The method of manufacturing a photoelectric conversion device according to any of claims 1 to 5, comprising:
forming the first electrode containing molybdenum on a main surface of a glass substrate, and
forming the semiconductor layer containing a chalcopyrite type compound,
wherein the isolating step is performed in a state in which the first electrode is left on the main surface of the glass substrate.

7. The method of manufacturing a photoelectric conversion device according to claim 2 or 3, further comprising covering the first portion or the second portion with a resin after the isolating.

8. The method of manufacturing a photoelectric conversion device according to claim 7, wherein the isolating is performed to provide a convex portion on a surface of the structure which is opposed to the first portion or the second portion.

9. The method of manufacturing a photoelectric conversion device according to any of claims 1 to 8, wherein the specifying serves to specify the spot having an abnormal physical property based on a light emission intensity through an electroluminescence of the structure in an application of a forward bias voltage to the structure.

10. The method of manufacturing a photoelectric conversion device according to any of claims 1 to 8, wherein the specifying serves to specify the spot having an abnormal physical property based on an intensity of an infrared ray emitted from the structure in an application of a forward bias voltage or a backward bias voltage to the structure.

11. The method of manufacturing a photoelectric conversion device according to claim 10, wherein the backward bias voltage is applied through a frequency modulation.

12. An apparatus for manufacturing a photoelectric conversion device including a mechanism for isolating a spot having an abnormal physical property in a structure comprising a photoelectric conversion member, including a semiconductor layer, between a pair of first and second electrodes, the apparatus comprising:
a voltage applying unit for applying a bias voltage to the structure;
a detecting unit for detecting an intensity of an electromagnetic wave emitted from the structure;
a specifying unit for specifying the spot having an abnormal physical property based on the intensity of the electromagnetic wave; and
a machining unit for carrying out machining over the structure to isolate the spot having an abnormal physical property.

13. A photoelectric conversion device comprising
a structure comprising a photoelectric conversion member, including a semiconductor layer, between a pair of first and second electrodes, and formed with the separation of a spot having an abnormal physical property by the machining.
